# EUROPEAN PATENT SPECIFICATION

(11) **EP 0 494 792 B1**
(45) Date of publication and mention of the grant of the patent: **04.12.1996**
(21) Application number: 92300222.4
(22) Date of filing: 10.01.1992
(51) Int. Cl.: C08F 12/22, C08F 12/32

(54) **Tetrahydropyranyloxystyrene homopolymer and method of manufacturing the same**
Tetrahydropyranyloxystyrol Homopolymer und Verfahren zu seiner Herstellung
Homopolymère de tetrahydropyranyloxystyrène et son procédé de fabrication

(30) Priority: 11.01.1991 JP 13898/91
(43) Date of publication of application: 15.07.1992
(73) Proprietor: Shin-Etsu Chemical Co., Ltd., Chiyoda-ku Tokyo 100 (JP)
(72) Inventor: Watanabe, Osamu, Aobadai Apart 309, Yokohama-shi, Kanagawa-ken (JP); Yamada, Motoyuki, Rinwa Sanny-court 404, Kawasaki-shi, Kanagawa-ken (JP); Yagihashi, Fujio, Aobadai Apart 101, Yokohama-shi, Kanagawa-ken (JP); Takamizawa, Minoru, Tokyo (JP)
(74) Representative: Dixon, Donald Cossar

(56) References cited:
- EP-A- 0 342 498
- EP-A- 0 443 415
- CHEMICAL ABSTRACTS, vol. 114, no. 22, 3 June 1991, Columbus, Ohio, US; abstract no. 217903D, HITACHI: 'Tetrahydropyranyl - and furanyl protected poly(hydroxystyrene) in chemical amplification systems.' page 733 ;column 2 ;

## Description

This invention concerns a polystyrene derivative and its method of manufacture, and in particular, a tetrahydropyranyloxystyrene homopolymer useful as a functional polymer and its method of manufacture.

Functional polymers have conventionally been widely used as resists in high resolution lithography for manufacturing LSI. In view of the current trends towards higher density, such resists are now being required to offer even higher resolution and higher developability. To meet these requirements, in the case of the novolak resins commonly used as resists, resolution and developability were increased by controlling the molecular weight of the polymer by means of fractionation (Japanese Tokkai Sho JP-A-62-217542 (unexamined publication)). Fractionation however involves a complicated procedure, and it requires a considerable time.

Recently, various chemically sensitized amplified types of resists are being studied with a view to replacing conventional resists. These resists are characterized in particular by their workability, due to the fact that they possess functional groups which can easily be eliminated by acids and to the fact that their solubility is different before and after the elimination.

From these viewpoints, styrene derivatives having excellent plasma resistance are well known, but they were unable to meet the increasingly stringent performance requirements.

Such polymers which were the main component of resists known in the art were obtained by ordinary radical polymerization or condensation polymerization, but no attempt was made to control their molecular weights or molecular weight distribution.

In this context, the Applicant carried out detailed studies of polystyrene derivatives in an effort to develop better functional polymers, and thereby discovered a tetrahydropyranyloxystyrene homopolymer which is extremely promising and forms the subject of this invention.

It is therefore an object of this invention to provide a tetrahydropyranyloxystyrene homopolymer which is useful as a resist with high resolution, and which has a narrow dispersion of molecular weight.

It is a further object of this invention to provide a method of manufacturing a tetrahydropyranyloxystyrene homopolymer which can be given any desired molecular weight with a narrow dispersion.

The above objects of the invention are achieved by a tetrahydropyranyloxystyrene homopolymer consisting of the repeating units represented by the following structural formula (1) , which has a narrow dispersion, as hereinbelow defined, of molecular weight, and a method of manufacturing said homopolymer:

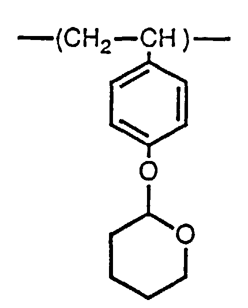

In accordance with this invention, the molecular weight distribution of the tetrahydropyranyloxystyrene homopolymer obtained is narrow, and as the molecular weight can be controlled to any desired value, the polymer can be expected to provide higher resolution than conventional polymers when used as a photosensitive material for resists.

Further, as it can be manufactured easily, this invention is of very great significance.

In the accompanying drawings:
Fig. 1 shows a ¹H-NMR spectrum of the polymer of this invention obtained by the method of Example 1; and
Fig. 2 shows a GPC elution curve of the polymer of this invention obtained by the method of Example 1; and
Fig. 3 shows a GPC elution curve of the polymer of this invention obtained by the method of Example 2.

The molecular weight distribution of the tetrahydropyranyloxystyrene homopolymer of this invention, having repeating units represented by the structural formula (1), is a narrow dispersion wherein the ratio of weight average molecular weight Mw to number average molecular weight Mn, Mw/Mn, is within the range of (1.03 - 1.50).

For this reason, resolution is greatly improved when this polymer is used as a resist.

The weight average molecular weight Mw can easily be calculated from the weight of monomer used and the molarity (the number of molecules) of an initiator used.

Further, the number average molecular weight (Mn) can be measured by a membrane osmometer. The molecular structure can easily be verified by the infrared absorption (IR) spectrum and ¹H-NMR spectrum, and the molecular weight distribution can be measured by performing gel permeation chromatography (GPC).

Next, we will describe a method of manufacturing the tetrahydropyranyloxystyrene homopolymer having a narrow dispersion of molecular weight according to this invention.

The tetrahydropyranyloxystyrene homopolymer of this invention can be manufactured by anionic polymerization of a tetrahydropyranyloxystyrene represented by the following structural formula (2):

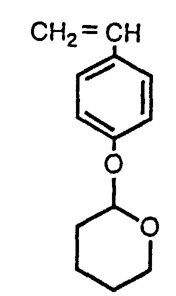

When the tetrahydropyranyloxystyrene is polymerized, it can be given a narrow dispersion of molecular weight by using any of the living anionic initiators known in the art, organometal compounds being particularly preferred.

The tetrahydropyranyloxystyrene homopolymer having a narrow dispersion of molecular weight according to this invention is then normally obtained as a living polymer.

The aforesaid organometal compound may be an organoalkali metal such as n-butyl lithium, sec-butyl lithium, naphthyl sodium, naphthyl potassium, anthryl sodium, disodium α-methylstyrene tetramer, cumyl potassium and cumyl cesium.

The aforesaid polymerization is normally conducted in an organic solvent. Organic solvents that can be used herein include aromatic hydrocarbons, cyclic ethers and aliphatic hydrocarbons (with specific examples including benzene, toluene, tetrahydrofuran, dioxane, tetrahydropyran, dimethoxyethane, n-hexane and cyclohexane) and mixtures of these solvents, but tetrahydrofuran is particularly preferable. The concentration of monomer used in the polymerization is 1 - 30 wt%, and the reaction is carried out with stirring under high vacuum or in an atmosphere of an inert gas Such as argon or nitrogen. The reaction temperature can be set to any temperature from -78°C to the boiling point of the solvent used. However when tetrahydrofuran is used as solvent the temperature preferably lies in the range - 78°C - 0°C, while when benzene is used it is preferably room temperature.

The polymerization reaction is carried out during a period of approx. 10 minutes - 5 hours. When the desired molecular weight is reached, a polymerization terminator such as methanol, water or methyl bromide is added to the reaction system to stop the reaction. In this way, a tetrahydropyranyloxystyrene homopolymer having a desired molecular weight can be obtained.

The reaction mixture can then be precipitated with, for example, methanol, and the product washed and dried to purify and separate it. The polymer thus manufactured is a polymer with residual polymerizing terminal sites which can easily be verified by the 1H-NMR spectrum.

The invention will now be described in more detail with reference to specific examples, but it should be understood that the invention is in no way limited to them.

### EXAMPLE 1

1.5 moles of dihydropyran and 1 mole of p-vinylphenol were introduced into a reaction vessel, and reacted at room temperature for 6 hours in methylene chloride solvent in the presence of 0.1 moles of pyridinium-p-toluene sulfonate.

After washing the reaction product with brine to remove the catalyst, it was distilled under reduced pressure to give tetrahydropyranyloxystyrene in 85% yield.

The tetrahydropyranyloxystyrene obtained had a boiling point of 120°C at 0.1 mm Hg.

This tetrahydropyranyloxystyrene monomer was then treated with CaH₂, distilled, and purified by sodium benzophenonate to remove water and other impurities, and used for polymerization.

700 ml of tetrahydrofuran solvent and 5x10 ⁻⁴ moles of n-butyl lithium as initiator were introduced into a 1 liter flask, the flask was cooled to -78°C, then 30 g of tetrahydropyranyloxystyrene diluted in 50 ml tetrahydrofuran was added and polymerized for 1 hour. The reaction liquid was red in color. Polymerization was continued so as to obtain the desired molecular weight, and methanol was added to stop the reaction. The reaction mixture was poured into methanol to precipitate the polymer which was then separated and dried. 29.5 g of a white polymer was obtained.

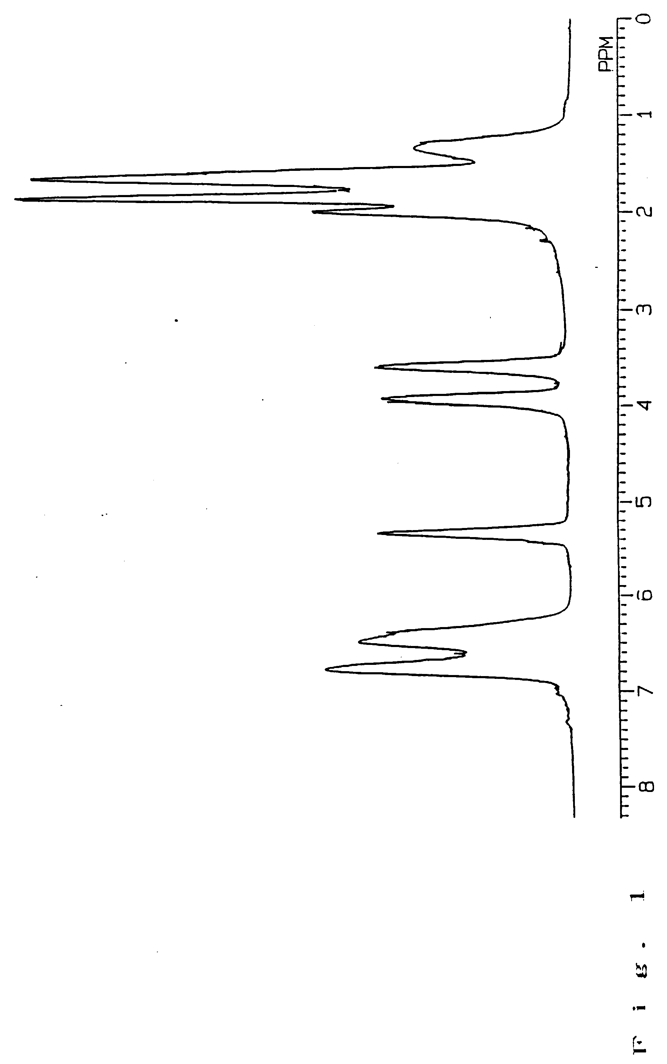

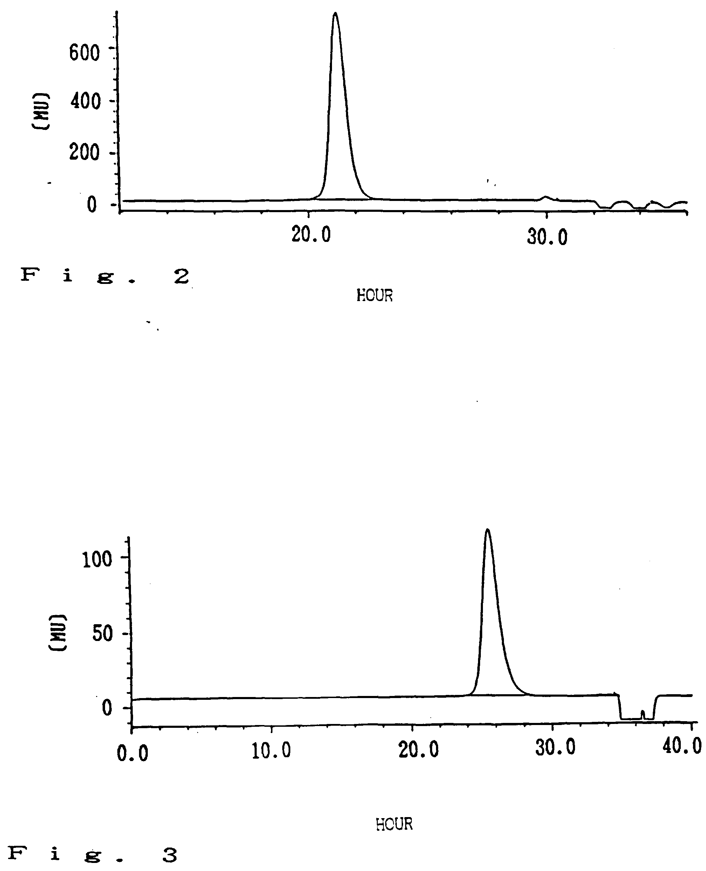

The ¹H-NMR spectrum of this polymer was as shown in Fig. 1, and its GPC elution curve was as shown in Fig. 2.

From the IR spectrum and ¹H-NMR spectrum, it was verified that the product was tetrahydropyranyloxystyrene homopolymer having reactive terminal sites which had not reacted on the tetrahydropyranyl groups bonded to ether, and wherein only the vinyl groups on the styrene fragment had reacted. The number average molecular weight of the polymer was found by membrane osmosis to be 5.5x10⁴ g/mole, and it was also verified from the GPC elution curve that the molecular weight had a narrow distribution very close to a monodispersion (i.e., a narrow dispersion).

### EXAMPLE 2

1 liter of tetrahydrofuran solvent and 3x10⁻³ moles of naphthyl potassium as initiator were introduced into a 2-liter flask, the mixture was cooled to 25°C and then 50 g of the purified tetrahydropyranyloxystyrene used in Example 1 diluted in 100 ml tetrahydrofuran was added and polymerized for 1 hour. The reaction liquid was red in color.

After verifying that the desired molecular weight had been obtained, methanol was added to the reaction solution to stop the reaction. Next, the reaction mixture was poured into methanol to precipitate the polymer which was then separated and dried. 49.5 g of a white polymer was obtained. The ¹H-NMR of this polymer showed similar specific absorptions to that of Example 1.

Further, from the GPC elution curve (Fig. 3), it was verified that the polymer obtained was very close to a monodispersion.

## Claims

1. A tetrahydropyranyloxystyrene homopolymer having a ratio of weight average molecular weight Mw to number average molecular weight Mn, Mw/Mn, within the range of 1.03 to 1.50 and consisting of repeating units represented by the following structural formula (1):

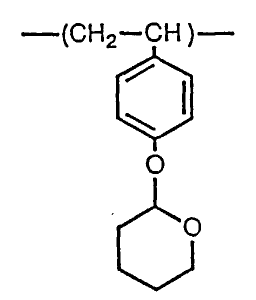

2. The tetrahydropyranyloxystyrene homopolymer as claimed in Claim 1, which is a living polymer.

3. A method of manufacturing a tetra hydropyranyloxystyrene homopolymer, which involves anionic living polymerization of a tetrahydropyranyloxystyrene represented by the following structural formula (2):

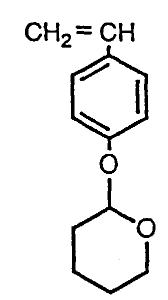

4. The method as claimed in Claim 3, which uses a living anionic initiator for said anionic living polymerization.

5. The method as claimed in Claim 4, wherein said living anionic initiator is an organometal compound.

6. The method as claimed in Claim 5, wherein said organometal compound is an organoalkali metal.

7. The method as claimed in Claim 6, wherein said organoalkali metal is at least one selected from among n-butyl lithium, sec-butyl lithium, naphthyl sodium, naphthyl potassium, anthryl sodium, disodium α-methylstyrene tetramer, cumyl potassium and cumyl cesium.

8. The method as claimed in any of Claims 3 to 7, wherein said anionic living polymerization is conducted in an organic solvent.

9. The method as claimed in Claim 8, wherein said organic solvent is at least one solvent selected from among aromatic hydrocarbons, cyclic ethers or aliphatic hydrocarbons.

10. The method as claimed in Claim 9, wherein said solvent is selected from benzene, toluene, tetrahydrofuran, dioxane, tetrahydropyran, dimethoxyethane, n-hexane and cyclohexane.

11. The method as claimed in Claim 10, wherein the solvent selected from tetrahydrofuran.

12. The method as claimed in Claim 11, wherein the reaction temperature is set in the range of -78°C to 0°C.

13. The method as claimed in Claim 10, wherein the solvent selected is benzene and the anionic living polymerization is carried out at room temperature.

14. The method as claimed in any of Claims 3 to 13, wherein the reaction is carried out under high vacuum or in an atmosphere of an inert gas.

15. The method as claimed in any of Claims 3 to 14, which further comprises the step of stopping the polymerization reaction by the addition of a polymerization terminator to the reaction system at the time when the polymer formed comes to have a desired molecular weight.

## Patentansprüche

1. Tetrahydropyranyloxystyrenhomopolymer mit einem Gewichtsverhältnis des Durchschnittsmolekulargewichts Mw zum Zahlenmittelmolekulargewicht Mn, Mw/Mn im Bereich zwischen 1,03 und 1,50 und bestehend aus sich wiederholenden Einheiten, wie sie durch die nachfolgende Strukturformel (1) wiedergegeben sind:

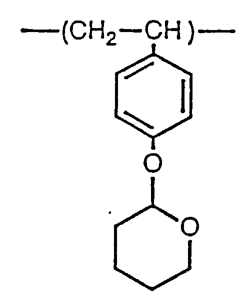

2. Tetrahydropyranyloxystyrenhomopolymer nach Anspruch 1, welches eine lebendes Polymer ist.

3. Verfahren zur Herstellung eines Tetrahydropyranyloxystyrenhomopolymers, welches eine anjonische Living-Polymerisation eines Tetrahydropyranyloxystyrens einschließt, wie es durch die folgende Strukturformel (2) wiedergegeben ist:

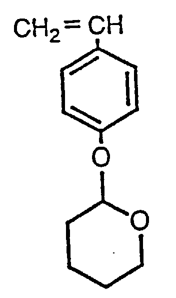

4. Verfahren nach Anspruch 3, welches einen lebenden anjonischen Initiator für die genannte anjonische Living-Polymerisation verwendet.

5. Verfahren nach Anspruch 4, bei welchem der genannte lebende anjonische Initiator eine Organometallverbindung ist.

6. Verfahren nach Anspruch 5, bei dem die genannte Organometallverbindung ein Organoalkalimetall ist.

7. Verfahren nach Anspruch 6, bei welchem das genannte Organoalkalimetall wenigstens eines ist, das ausgewählt ist aus n-Butyllithium, sec-Butyllithium, Naphtylnatrium, Naphtylkalium, Anthrylnatrium, Disodium α-Methylstyrentetramer, Cumylkalium oder Cumylcesium.

8. Verfahren nach Anspruch 3, bei welchem die genannte anjonische Living-Polymerisation in einem organischen Lösungsmittel ausgeführt wird.

9. Verfahren nach Anspruch 8, bei welchem das organische Lösungsmittel wenigstens ein Lösungsmittel ist, das ausgewählt wurde unter aromatischen Kohlenwasserstoffen, zyklischen Ethern oder aliphatischen Kohlenwasserstoffen.

10. Verfahren nach Anspruch 9, bei welchem das Lösungsmittel ausgewählt wurde unter Benzol, Toluol, Tetrahydrofuran, Dioxan, Tetrahydropyran, Dimethoxaethan, n-Hexan und Cyclohexan.

11. Verfahren nach Anspruch 10, bei welchem das Lösungsmittel Tetrahydrofuran ist.

12. Verfahren nach Anspruch 11, bei welchem die Reaktionstemperatur im Bereich von -78°C bis 0°C liegt.

13. Verfahren nach Anspruch 10, bei welchem das ausgewählte Lösungsmittel Benzol ist und die anjonische Living-Polymerisation bei Raumtemperatur durchgeführt wird.

14. Verfahren nach einem der Ansprüche 3 bis 13, bei welchem die Reaktions unter Hochvakuumbedingungen oder in einerAtmosphäre eines inerten Gases ausgeführt wird.

15. Verfahren nach einem der Ansprüche 3 bis 14, welches darüber hinaus den Schritt des Stoppens der Polymerisationsreaktion durch Zufügen eines Polymerisationsbeendigers zum Reaktionssystem zu dem Zeitpunkt umfaßt, wenn das gebildete Polymer das gewünschte Molekulargewicht erreicht.

## Revendications

1. Homopolymère de tétrahydropyrannyloxystyrène ayant un rapport de la masse moléculaire moyenne en masse Mw à la masse moléculaire moyenne en nombre Mn, Mw/Mn, comprise entre 1,03 et 1,50, et constitué de motifs répétitifs représentés par la formule développée suivante (1) :

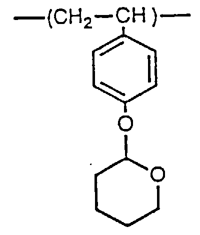

2. Homopolymère de tétrahydropyrannyloxystyrène selon la revendication 1, qui est un polymère vivant.

3. Procédé de fabrication d'un homopolymère de tétrahydropyrannyloxystyrène, qui met en jeu une polymérisation vivante anionique d'un tétrahydropyrannyloxystyrène représenté par la formule développée suivante (2) :

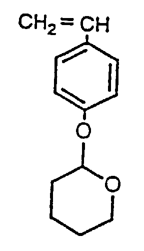

4. Procédé selon la revendication 3, qui utilise un amorceur anionique vivant pour ladite polymérisation vivante anionique.

5. Procédé selon la revendication 4, dans lequel ledit amorceur anionique vivant est un composé organométallique.

6. Procédé selon la revendication 5, dans lequel ledit composé organométallique est un composé organoalcalin.

7. Procédé selon la revendication 6, dans lequel ledit composé organoalcalin est au moins un composé choisi parmi le n-butyl-lithium, le sec-butyl-lithium, le naphtyl-sodium, le naphtyl-potassium, l'anthryl-sodium, le tétramère d'α-méthylstyrène disodique, le cumyl-potassium et le cumyl-césium.

8. Procédé selon l'une quelconque des revendications 3 à 7, dans lequel ladite polymérisation vivante anionique se déroule dans un solvant organique.

9. Procédé selon la revendication 8, dans lequel ledit solvant organique est au moins un solvant choisi parmi les hydrocarbures aromatiques, les éthers cycliques et les hydrocarbures aliphatiques.

10. Procédé selon la revendication 9, dans lequel ledit solvant est choisi parmi le benzène, le toluène, le tétrahydrofuranne, le dioxanne, le tétrahydropyranne, le diméthoxyéthane, le n-hexane et le cyclohexane.

11. Procédé selon la revendication 10, dans lequel le solvant choisi est le tétrahydrofuranne.

12. Procédé selon la revendication 11, dans lequel la température de la réaction est comprise dans l'intervalle allant de -78°C à 0°C.

13. Procédé selon la revendication 10, dans lequel le solvant choisi est le benzène et la polymérisation vivante anionique se déroule à la température ambiante.

14. Procédé selon l'une quelconque des revendications 3 à 13, dans lequel la réaction se déroule sous un vide poussé ou dans une atmosphère d'un gaz inerte.

15. Procédé selon l'une quelconque des revendications 3 à 14, qui comprend en outre l'étape consistant à arrêter la réaction de polymérisation par l'addition au système réactionnel d'un rupteur de polymérisation au moment où le polymère formé atteint une masse moléculaire souhaitée.
